# EUROPEAN PATENT SPECIFICATION

(11) **EP 0 481 743 B1**
(45) Date of publication and mention of the grant of the patent: **24.03.1999**
(21) Application number: 91309510.5
(22) Date of filing: 16.10.1991
(51) Int. Cl.: G01R 31/36

(54) **Method of displaying a residual electric charge in a battery of an electrically driven vehicle**
Verfahren, die verbleibende elektrische Ladung der Batterie eines elektrisch betriebenen Fahrzeugs anzuzeigen
Méthode pour indiquer la charge résiduelle d'une batterie d'un véhicule à impulsion électrique

(30) Priority: 16.10.1990 JP 277263/90
(43) Date of publication of application: 22.04.1992
(73) Proprietor: HONDA GIKEN KOGYO KABUSHIKI KAISHA, Minato-ku Tokyo (JP)
(72) Inventor: Nakazawa, Yoshihiro, c/o K. K. Honda, Wako-shi, Saitama (JP); Honda, Satoshi, c/o K. K. Honda, Wako-shi, Saitama (JP); Suzuki, Hiroyuki, c/o K. K. Honda, Wako-shi, Saitama (JP); Sasaki, Shigemi, c/o K. K. Honda, Wako-shi, Saitama (JP)
(74) Representative: Tomlinson, Kerry John

(56) References cited:
- DE-A- 3 218 148
- DE-A- 3 311 723
- DE-A- 3 321 045
- DE-A- 3 321 649
- DE-A- 3 429 145
- DE-A- 3 823 038
- GB-A- 2 116 728

## Description

The invention relates to a method of displaying residual electric charge of a battery used in an electrically driven vehicle.

Electrically-driven vehicles which use batteries as driving power have been developed so far.

Since the distance, along which such an electrically driven vehicle can run, much depends on the residual electric charge of its battery, it is necessary to equip the electrically driven vehicle with a battery residual electric charge meter for displaying the residual electric charge of the battery all the time. A typical battery residual electric charge meter has been disclosed in Japanese Utility Model Laid-open No. 50-45628.

With the conventional technology, a shunt is connected in series with the battery and a direct-current motor is hooked up in parallel with the shunt. A movable needle is coupled to the direct-current motor through a friction joint. The needle is equipped with a reset means for moving the needle using a slip relative to the motion of the direct-current motor.

When charging the battery, current flows from a charger to the battery, causing the direct-current motor to rotate in a certain direction and the needle to swing toward a charging direction. When current is being supplied to the battery's loads such as the electric motor, the direct-current motor rotates in the reversed direction, causing the needle to swing toward a discharging direction by an angle proportional to electric power consumed out of the battery.

When the needle of the battery residual electric charge meter is swinging in the charging direction during charging, the movement of the needle can be halted at a predetermined position using a stopper to indicate a fully charged state even if the charging is still going on. On the other hand, the needle may not have reached the predetermined halt position described above even if the charging of the battery is completed. In this case, however, the reset means can be used to forcibly swing the needle to the predetermined halt position indicating a fully charged state.

With the technology described above, however, while the battery is being charged, the movement of the needle can be halted by the stopper to indicate a fully charged state even if the charging is incomplete. In addition, the needle may not swing to the predetermined halt position upon the completion of the charging. Nevertheless, in this case the needle can be forcibly swung to indicate the fully charged state. Anyway, a phenomenon which shows a discrepancy between the electric charge actually left in the battery and the indicated residual electric charge does occur.

As described earlier, the distance, along which such an electronically driven vehicle can run, much depends on the residual electric charge of its battery. Accordingly, the above phenomenon also indicates the discrepancy between the visual information on the residual electric charge of the battery indicated by the needle of the battery residual electric charge meter and the distance along which the vehicle is able to run.

In addition, the total capacity of the battery at the charging time gradually decreases with the lapse of time. The charging and discharging of the battery themselves also contribute to the decrease in total capacity. Accordingly, it can be presumed that the above problem is made even more serious by the decreasing battery capacity.

Improvement is thus desirable.

DE-A-3429145 describes a method for determining the state of charge in a battery in which the used battery capacity is measured as a function of current and voltage. The average current is calculated, the total battery capacity calculated therefrom, and the state of charge is determined as a function of the used battery capacity and the total battery capacity. The preamble to claim 1 is based on this document.

DE-A-3218148 describes a battery discharge state indicating a system in which a warning is given when the discharge sum reaches a certain value.

DE-A-3321045 describes a battery state of charge evaluator for an electrical vehicle which calculates the charge withdrawn from the battery based on current supplied to electrical loads, and calculates the remaining battery charge as a function of voltage.

DE-A-3823038 describes a battery charge monitoring device which uses a counter to calculate the charge dissipated from a battery.

GB-A-2116728 describes a battery charge monitor in which a microprocessor calculates remaining battery capacity on the basis of an input nominal initial battery capacity and the current flowing from the battery.

The present invention provides techniques for displaying the battery residual electric charge of an electrically driven vehicle described as follows.

A technique for displaying a residual electric charge in a battery according to the invention provides a method of displaying a residual electric charge in a battery of an electrically driven vehicle, in which a fully charged capacity of said battery is determined, calculation of consumed charge based on current supplied to electrical loads of said electrically driven vehicle is performed, the calculated consumed charge is then subtracted from said fully charged capacity to give a battery residual electrical charge and a battery residual electrical charge meter is driven at one time in accordance with the determined result of said fully charged capacity and at another time in accordance with the calculated result of said battery residual electric charge, characterized in that said fully charged capacity of said battery is determined by the following steps: determining if said battery is in a state of being charged; if said battery is in a state of being charged, checking whether the electric charging has finished or not; and when the electric charging is determined to be finished, determining said fully charged capacity of said battery by initially measuring said fully charged capacity after the end of charging of said battery.

With the technique for displaying a residual electric charge in a battery of an electrically driven vehicle according to the invention, the battery is charged and at the time the electric charging is completed, the battery capacity is detected and the battery residual electric charge meter is driven to indicate a fully charged state of the battery.

As the battery begins to supply current to electrical loads, consumed charge is calculated from a product of the value of the current and the length of the time during which the current has been supplied. The calculated value of the consumed charge is subtracted from the fully charged capacity from time to time in order to derive a residual electric charge. The battery residual electric charge meter is driven in accordance with the derived value to indicate a current residual electric charge.

As such, the battery residual electric charge meter displays values which depend upon the actual full electric charge and residual electric charges to very accurately provide the driver with information on a residual electric charge in the battery or a distance that the electrically driven vehicle can run, and the time to recharge the battery as visual information.

Preferably the measurement of a fully charged capacity of the battery is performed after a predetermined period of time has elapsed since the end of the charging of the battery.

In this way, a fully charged capacity is measured after the battery has entered a post-charging stable state. Accordingly, an error in the calculated residual charge relative to the actual charge can be further reduced and the display of the battery residual electric charge meter can be made more reliable.

Preferably after a fully charged capacity of the battery is measured by detecting the voltage of the battery, compensation based on the temperature of the battery is performed to compute an actual capacity.

In this way, the real capacity of the battery at the end of the electric charging can be measured very accurately. As a result, the error in the display of the battery residual electric charge meter is reduced.

Preferably the measurement of a fully charged capacity of the battery is performed by comparing an electric charge discharged from the battery during a predetermined period of charge-consumption time to a reference discharge characteristic found in advance.

The driving of the battery residual electric charge meter is based on the comparison result to display a value with a difference between the actual charge and the reference battery capacity taken into consideration. In this way, the life of the battery is indicated and the appropriate time to replace the battery can be well identified in advance.

Certain embodiments of the invention will now be described by way of example only and with reference to the accompanying drawings, in which:
Fig. 1 is a block diagram of a control system in an electrically driven vehicle for implementing the invention;
Fig. 2 is a flow chart used for explaining a first embodiment of the invention;
Fig. 3 shows relations between the discharge capacity and the number of charging and discharging times for different discharge rates;
Fig. 4 shows relations between the discharge amount and the number of charging times;
Figs. 5, 6 and 7 show simplified front views of a battery residual electric charge meter;
Fig. 8 is a flowchart used for explaining a second embodiment of the invention;
Fig. 9 is a flowchart used for explaining a third embodiment of the invention;
Fig. 10 shows battery characteristics indicating relations between the battery voltage and the discharge time.

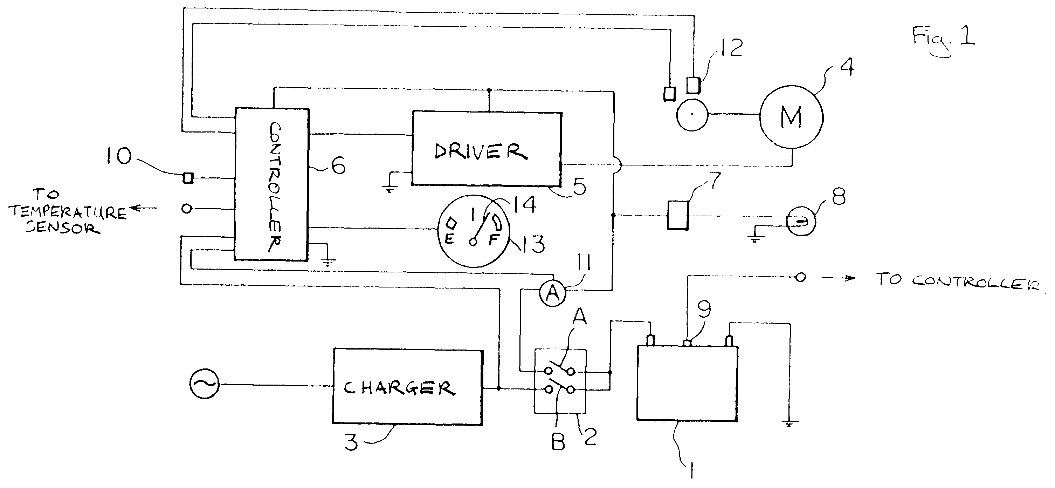

Referring to Fig. 1 to 7, a first embodiment implemented according to the invention is described as follows.

Fig. 1 shows a block diagram of an apparatus implementing a technique adopted by the embodiment. Reference numeral 1 shown in the figure is a battery. Reference numeral 2 is a combination switch connected to the plus terminal of the battery 1. The combination switch 2 comprises a driving switch A and a charging switch B.

Reference numeral 3 is a charger connected to the charging switch B of the combination switch 2 described above. When the electric charging of the battery 1 by means of the charger 3 is completed, the charging switch B is automatically turned off.

Even though Fig. 1 shows the charging switch B embedded in the combination switch 2, as another typical alternative, the charging switch B can also be embedded in the charger 3. What is essential is that it must be a switch that turns off at the end of the electric charging some time after the charging of the battery 1 is started.

A preferred procedure for determining the end of the charging comprises detecting when the battery voltage becomes higher than a reference voltage; thereafter detecting when the current becomes lower than a reference current and timing a predetermined time after the current becomes lower than the reference current.

The driving switch A is connected to a driver 5 for controlling current supplied to an electric motor 4 and a controller 6 which is connected to the driver 5 for controlling its operation. The driving switch A is also connected to an electrical load 8 such as a lamp through a down converter 7.

The controller 6 is electrically connected to a temperature sensor 9 mounted on the battery 1, a throttle sensor 10 for detecting the position of a throttle control for adjusting the speed of the electrically driven vehicle, an ampere meter 11 for measuring driving current supplied to the lamp 8, etc., a speed sensor 12 for monitoring the rotational speed of the electric motor 4 and a battery residual electric charge meter 13 for displaying the residual electric charge in the battery 1.

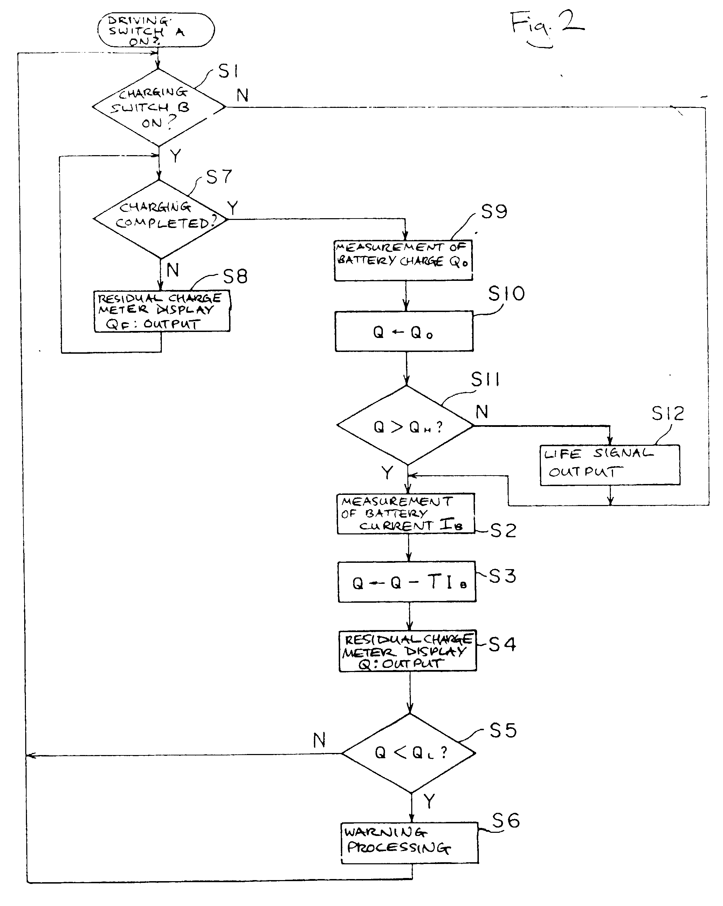

The apparatus whose configuration is shown in Fig. 1 serves as an embodiment of the invention. The description of a technique for displaying the battery residual electric charge is based on a flowchart shown in Fig. 2.

The description begins with a case in which the electrically driven vehicle starts running with the battery 1 fully charged.

Control shown in the flowchart is commenced at the time the driving switch A is turned on to supply current to electrical loads of the electrically driven vehicle such as the lamp 8 and the electric motor 4. Steps taken to implement the control are described as follows:

### Step S1

The first step is to check whether the charging switch B is turned on or off. The control flow continues to a next step S2 only if the charging switch B is turned off.

### Step S2

Driving current is supplied to the electric motor 4, lamp 8, etc. from the battery 1, gradually consuming electric charge accumulated in the battery.

In the step S2, a battery current I_{B}, the driving current supplied to the electrical loads, is continuously monitored by means of a signal coming from the ampere meter 11 which is connected in the path of the driving current flowing from the battery 1. At the same time, the controller 6 measures the length of the time T the driving current is supplied before proceeding to a next step S3.

### Step S3

The battery current I_{B} and the supply time T respectively monitored and measured at the step S2 are used to compute a consumed charge (capacity) T.I_{B}. The consumed charge T.I_{B} is subtracted from a battery residual electric charge Q to give a new battery residual electric charge Q which is stored as an updated value before continuing to a next step S4.

The new electric charge Q is the battery residual electric charge Q in the battery 1 at this point of time.

### Step S4

The controller 6 provides the battery residual electric charge meter 13 with a driving signal based on information on the updated residual electric charge Q of the battery 1 computed at the step S3.

Receiving the driving signal, the battery residual electric charge meter 13 displays information corresponding to the battery residual electric charge Q, before proceeding to a next step S5.

### Step S5

The residual electric charge Q updated at the step S3 is compared to a lower-limit Q_{L}, a charge limit set in advance under which the battery cannot be used. If the residual electric charge Q is equal to or greater than the lower limit Q_{L}, the residual charge in the battery 1 is determined to be sufficient enough for driving use and the control flow returns to the step S1. If the residual electric charge Q is smaller than the lower limit Q_{L}, the control flow continues to a next step S6.

### Step S6

When the residual electric charge Q becomes smaller than the charge lower limit Q_{L}, the battery 1 is determined to be no longer capable of providing sufficient power for running the electrically driven vehicle. In this case, a display means such as a warning lamp is activated to notify the driver that the battery 1 needs to be recharged. The control flow then returns to the step S1.

The charge lower limit Q_{L} is typically set at 60% of the total chargeable capacity of the battery 1.

A comparison study was done on the way the battery 1 is used. In one case, the battery 1 is used at discharge rates in the range 80% to 100% or at an average discharge rate of 90%. In another case, the same battery 1 is used at an average discharge rate of 80%. At the average discharge rate of 90%, it is possible to discharge the battery to 80% of the initial charge much fewer times than at the average rate of 80% as shown in Fig. 3.

That is to say, the total charge that can be consumed from the battery 1 at an average discharge rate of 90% becomes smaller.

In addition, when the warning lamp is turned on, it takes some time to drive the vehicle to a station where the battery can be actually recharged. The charge lower limit Q_{L} set at 60% is based on an assumption that in order to drive the vehicle to the recharging station, it requires 20% of the battery capacity.

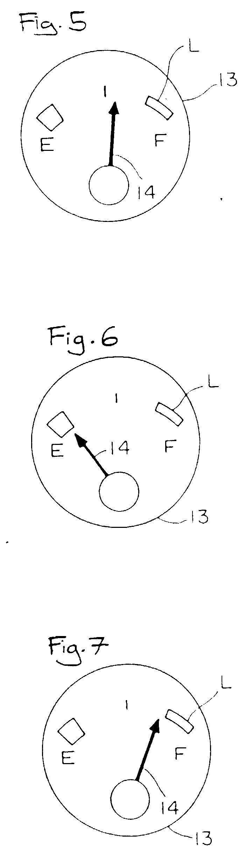

Display states of the battery residual electric charge meter 13 driven by the described control technique are shown in Fig. 5 and 6.

Fig. 5 shows a needle position indicating that the residual charge Q is greater than the charge lower limit Q_{L} whereas Fig. 6 shows a needle position indicating a residual charge Q smaller than the charge lower limit Q_{L}.

By the way, if the charging switch B is found turned on at the step S1, the battery 1 is determined to be in a state of being charged. In this case, the control flow goes to a step S7 and its subsequent steps.

### Step S7

This step is to check whether the electric charging has been finished or not. If not completed, the control flow continues to a step S8. Otherwise, it proceeds to a step S9.

In this embodiment, the completion of the electric charging is determined by the state of the charging switch B. That is to say, the charging switch B is turned off upon the completion of the electric charging.

### Step S8

A driving signal is transmitted to the battery residual electric charge meter 13 to indicate a fully charged state. The control flow then returns to the step S7 described previously.

### Step S9

When the electric charging is determined to be completed at the step S7, the voltage and the full charge Q₀ of the battery 1 are measured. Correction based on temperature information of the battery 1 obtained from the temperature sensor 9 is then performed before proceeding to a step S10.

### Step S10

The full charge Q₀ measured and corrected at the step S9 is stored as an updated initial charge Q before proceeding to a step S11.

### Step S11

At this step, the initial charge Q is compared to a minimum full charge Q_{H} which is set in advance. If the initial charge Q is greater than the minimum full charge Q_{H}, the control flow continues to the step S2. Otherwise, it proceeds to a step S12.

### Step S12

If the initial charge Q is smaller than the minimum full charge Q_{H}, the initial charge Q is determined to be insufficient for driving the vehicle into a predetermined running state. In this case, the battery 1 is deemed no longer usable and the residual electric charge meter 13 is driven to indicate this state accordingly. The control flow then continues to the step S2.

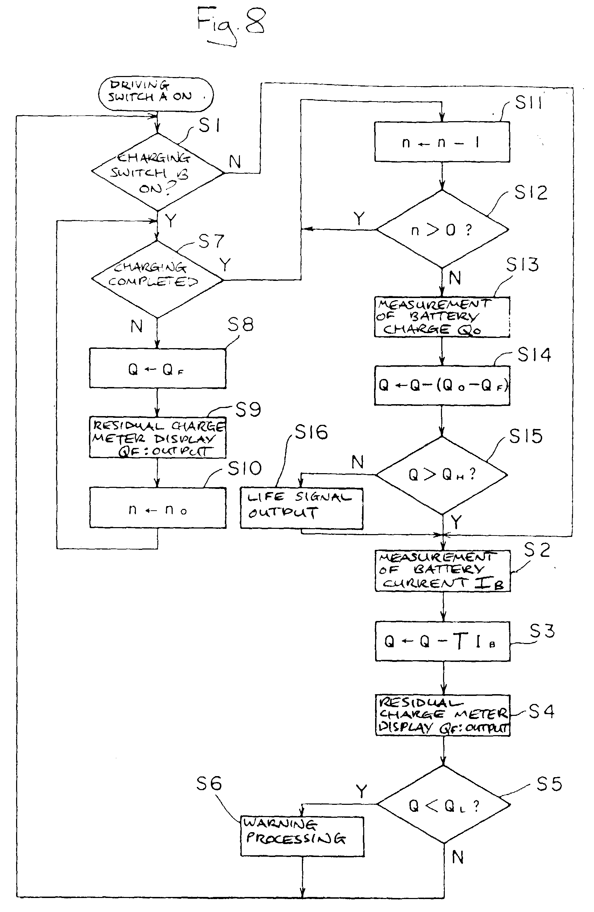

In this embodiment, the ended life of the battery 1 is indicated by using a life zone L shown in Fig. 7. The life zone L is provided above a position of the needle 14 which corresponds to the minimum full charge Q_{H}. The ended life of the battery 1 is indicated by placing the needle 14 at a position below the life zone L.

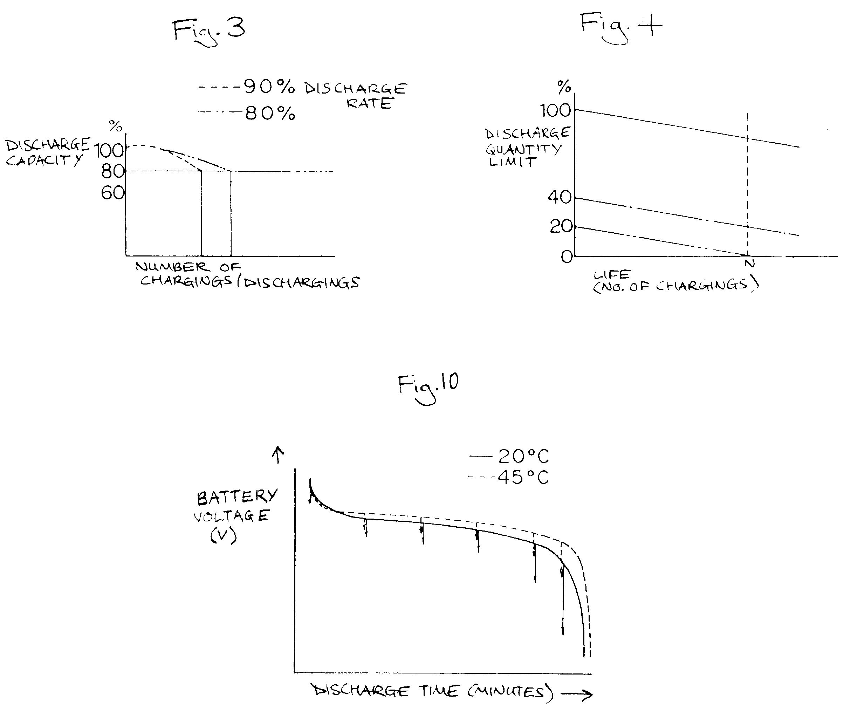

When a usage condition is set to limit the discharge quantity within 80%, the number of times N discharging can be performed can be derived theoretically from Fig. 4. Inversely, for a given value of the number of times N discharging can be performed, the usage condition determining the discharge quantity limit can be set.

As such, according to the technique for displaying a residual electric charge in the battery 1 adopted by the embodiment, a full charge Q₀ of the battery 1 right after electric charging is directly measured and displayed by the battery residual electric charge meter 13. A discharged quantity is monitored and subtracted from the full charge Q₀ to give an updated charge Q which is used to drive the battery residual electric charge meter 13. Subsequently, the monitoring of a discharge quantity and the subtracting it from the updated charge Q are done continuously to give a new updated value Q which, in turn, keeps the display of the battery residual electric charge meter 13 updated all the time. In this way, the display of the battery residual electric charge meter 13 always almost completely matches the electric charge that is actually left in the battery 1.

Accordingly, the residual electric charge in the battery 1 can be seen as very accurate visual information.

In addition, since the embodiment implements temperature correction on the initially measured full charge Q₀ of the battery 1, the full charge Q₀ can be made even more accurate. Furthermore, since the display of the battery residual electric charge meter 13 is based on the corrected value of the full charge Q₀, the correction and the displaying of the visual information can be carried out easily and reliably.

Moreover, the full charge Q₀ is compared to a minimum full charge Q_{H} to identify the current life expectancy of the battery 1. In this way, the time to replace the battery 1 can be known easily and correctly.

Referring to Fig. 8, a second embodiment of the invention is explained.

Steps S1 to S6 are the same as described with reference to Fig. 2.

If the charging switch B is found turned on at the step S1, the battery 1 is determined to be in a state of being charged. In this case, the control flow goes to a step S7 and its subsequent steps.

### Step S7

This step is to check whether the electric charging has been finished or not. If not completed, the control flow continues to a step S8.

### Step S8

The residual electric charge Q is stored as a full charge Q_{F} and the control flow continues to a step S9.

### Step S9

The battery residual electric charge meter 13 is driven by a signal based on information on the full electric charge Q_{F} to display full charge information and the control flow continues to a step S10.

### Step S10

An initial value n₀ is stored as a counter value n and the control flow returns to the step S7.

### Step S11

When the electric charging is determined to be complete at the step S7, the counter value n is decremented by 1 to n-1 and the value n-1 is stored as a new counter value. The control flow then continues to a step S12.

### Step S12

The updated counter value n is compared to zero. If n is equal to or smaller than zero, the control flow proceeds to a step S13. Otherwise, the control flow returns to the step S11.

The steps S11 and S12 constitute a counter to delay the transition from the step S7 to the step S13 by a time the length of which is proportional to the initial value no of the counter stored at the step S10.

### Step S13

The voltage and the full electric charge Q₀ of the battery 1 are measured and the full electric charge Q₀ is corrected using information on the temperature of the battery 1 obtained from the temperature sensor 9. The control flow then proceeds to a step S14.

### Step S14

A residual charge Q is computed using the following formula:

Q - (Q_{F}-Q₀)

where Q is the electric charge Q updated at the step S8, Q₀ is the full electric charge measured and corrected at the step S13 and Q_{F} is the maximum full electric charge. The computed residual electric charge is stored and the control flow continues to a step S15.

The above formula subtracts the difference between the maximum full electric charge Q_{F} and the measured full electric charge Q₀ from the residual electric charge Q to give an actual residual-electric charge.

### Step S15

The full electric charge Q is compared to a minimum full electric charge Q_{H} which is set in advance. If the former is larger than the latter, the control flow proceeds to the step S2. Otherwise, it continues to the step S16.

### Step S16

A full electric charge Q being smaller than the minimum full electric charge Q_{H} is indicated by the battery residual electric charge meter 13. The control flow returns to the step S2.

According to the technique for displaying a residual electric charge of the battery 1 adopted by this embodiment, the full electric charge Q₀ is measured at a predetermined time after the end of the electric charging. The period between the end of the electric charging and the measurement time is set by the steps S10 to S13. Accordingly, the full electric charge Q₀ is measured after the battery 1 has entered a stable state.

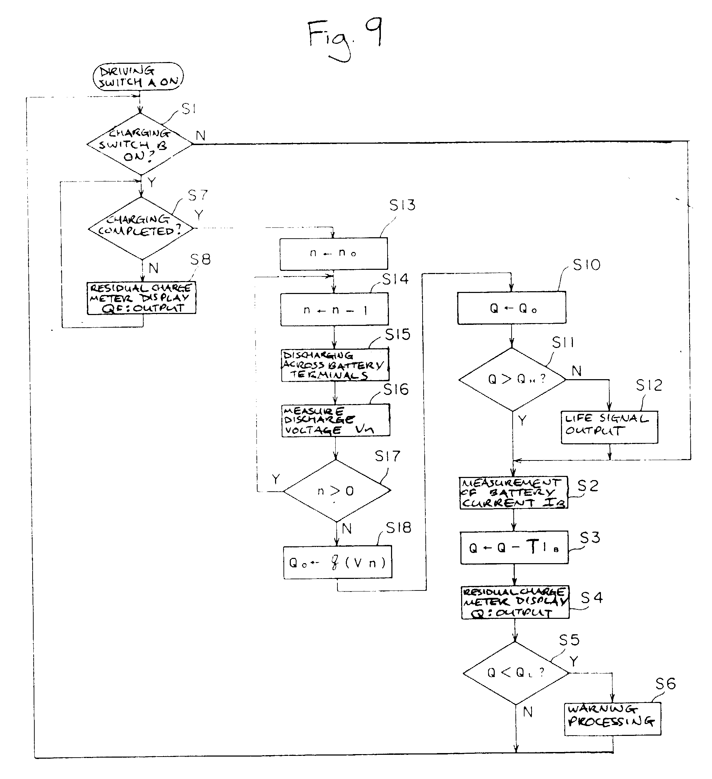

As a result, the full charge can be measured very accurately. Fig. 9 shows a third embodiment of the invention.

Steps S1 to S8 and steps S10 to S12 for this embodiment are the same as those for the first embodiment. The step S9 is converted into the following control flow.

### Step S13

When the electric charging is determined to be complete at the step S7, the counter value n is set to the predetermined value n₀ and stored. The control flow then continues to a step S14.

### Step S14

The counter value n is decremented by 1 to n-1 and stored. The control flow then proceeds to a step S15.

### Step S15

Current is allowed to flow for a predetermined period of time, for example a few seconds, through the lamp 8, etc. which serve as resistors across both terminals of the battery 1. The control flow then proceeds to a step S16.

### Step S16

A discharge voltage Vₙ is measured and stored at the same time as the processing carried out at the step S15. The control flow then continues to a step S17.

### Step S17

The counter value n is compared to zero. If it is equal to or smaller than zero, the control flow continues to a step S18. Otherwise, it returns to the step S14.

Like the second embodiment, the steps S13, S14 and S17 constitute a counter.

### Step S18

The battery voltage Vₙ measured at the step S16 undergoes temperature correction before being compared to a discharge characteristic found in advance to determine a corresponding full charge q. The full charge q is stored as a full charge Qₒ. The control flow then continues to the step S10 and its subsequent steps.

The discharge voltage at full charge varies proportionally to a saturated capacity of the battery 1 with the full charge. Thus, the amount of capacity deterioration of the battery 1 can be derived accurately by comparing a discharge voltage to a discharge characteristic found in advance according to the technique for displaying a residual electric charge in the battery 1 adopted by the third embodiment. As a result, a charge actually left in the battery 1 can be displayed immediately on the battery residual electric charge meter 13 as visual information.

It should be noted that the embodiments described above are no more than preferred examples. The control procedure can thus be changed in accordance with a variety of design requirements. For example, the embodiment in which a full charge is derived by comparing a discharge voltage to a known discharge characteristic has been given. However, the discharge voltage changes with discharge time as shown in Fig. 10. Accordingly, by performing this control at the time the driving switch A is turned on, the residual electric charge can be initialized when the vehicle starts running at a time the battery 1 is not being charged.

## Claims

1. A method of displaying a residual electric charge in a battery of an electrically driven vehicle, in which a fully charged capacity of said battery is determined, calculation of consumed charge based on current supplied to electrical loads of said electrically driven vehicle is performed (S2), the calculated consumed charge is then subtracted (S3) from said fully charged capacity to give a battery residual electrical charge and a battery residual electrical charge meter is driven (S4) at one time in accordance with the determined result of said fully charged capacity and at another time in accordance with the calculated result of said battery residual electric charge, characterized in that said fully charged capacity of said battery is determined by the following steps:
determining (S1) if said battery is in a state of being charged;
if said battery is in a state of being charged, checking (S7) whether the electric charging has finished or not; and
when the electric charging is determined to be finished, determining said fully charged capacity of said battery by initially measuring (S9,S13,S13-S17) said fully charged capacity after the end of charging of said battery.

2. A method according to claim 1 characterized in that the measurement of said fully charged capacity of said battery is performed after a predetermined period of time has elapsed (S10-S12, Fig. 8) since the end of the charging of said battery.

3. A method according to claim 1 or 2 characterized in that said fully charged capacity of said battery is measured by detecting the voltage of said battery, and after said fully charged capacity of said battery is measured, compensation based on the temperature of said battery is performed to compute an actual charged capacity (S9,S13,S13-S18).

4. A method according to claim 1, 2 or 3 characterized in that the measurement of said fully charged capacity of said battery is performed by comparing a discharge voltage of said battery during a predetermined period of time to a reference discharge characteristic found in advance (S15, S16, Fig. 9).

## Patentansprüche

1. Verfahren zur Anzeige einer elektrischen Restladung in einer Batterie eines elektrisch angetriebenen Fahrzeugs, bei dem eine Volladekapazität der Batterie ermittelt wird, eine Berechnung einer verbrauchten Ladung auf Grundlage des elektrischen Lasten des elektrisch angetriebenen Fahrzeugs gelieferten Stroms durchgeführt wird (S2), die berechnete verbrauchte Ladung sodann von der Volladekapazität abgezogen wird (S3), um eine elektrische Batterierestladung bereitzustellen, und ein elektrischer Batterierestladungsmesser einmal entsprechend dem ermittelten Ergebnis der Volladekapazität und ein anderesmal entsprechend dem berechneten Ergebnis der elektrischen Batterierestladung angesteuert wird (S4),
**dadurch gekennzeichnet**, daß die Volladekapazität der Batterie mittels der folgenden Schritte ermittelt wird:
- Ermitteln (S1), ob sich die Batterie in einem Zustand des Geladenwerdens befindet,
- falls sich die Batterie in einem Zustand des Geladenwerdens befindet, Prüfen (S7), ob das elektrische Laden beendet ist oder nicht, und
- wenn das elektrische Laden als beendet bestimmt wird, Ermitteln der Volladekapazität der Batterie durch anfängliches Messen (S9, S13, S13 - S17) der Volladekapazität nach dem Ende des Ladens der Batterie.

2. Verfahren nach Anspruch 1, **dadurch gekennzeichnet**, daß die Messung der Volladekapazität der Batterie durchgeführt wird, nachdem eine vorbestimmte Zeitdauer seit dem Ende des Ladens der Batterie verstrichen ist (S10 - S12, Figur 8).

3. Verfahren nach Anspruch 1 oder 2, **dadurch gekennzeichnet**, daß die Volladekapazität der Batterie gemessen wird, indem die Spannung der Batterie erfaßt wird, und daß nach Messung der Volladekapazität der Batterie eine Kompensation auf Grundlage der Temperatur der Batterie durchgeführt wird, um eine aktuelle Ladekapazität zu berechnen (S9, S13, S13 - S18).

4. Verfahren nach Anspruch 1, 2 oder 3, **dadurch gekennzeichnet**, daß die Messung der Volladekapazität der Batterie durch Vergleich einer Entladespannung der Batterie während einer vorbestimmten Zeitdauer mit einer im voraus aufgefundenen Referenzentladecharakteristik durchgeführt wird (S15, S16, Figur 9).

## Revendications

1. Méthode pour indiquer la charge résiduelle d'une batterie d'un véhicule à impulsion électrique, dans laquelle la capacité à pleine charge de ladite batterie est déterminée, un calcul de la charge consommée basé sur le courant appliqué à des charges électriques dudit véhicule à impulsion électrique est effectué (S2), la charge consommée calculée est ensuite soustraite (S3) de ladite capacité à pleine charge afin de donner une charge résiduelle de batterie et un appareil de mesure de charge résiduelle de batterie est commandé (S4) à un moment en fonction du résultat déterminé de ladite capacité à pleine charge et à un autre moment en fonction du résultat calculé de ladite charge résiduelle de batterie, caractérisée en ce que ladite capacité à pleine charge de ladite batterie est déterminée par les étapes suivantes consistant à :
déterminer (S1) si ladite batterie est en train d'être chargée;
si ladite batterie est en train d'être chargée, contrôler (S7) si l'opération de charge est terminée ou non ; et
quand l'opération de charge est déterminée comme étant terminée, déterminer ladite capacité à pleine charge de ladite batterie en mesurant (S9, S13, S13-S17) initialement ladite capacité à pleine charge après la fin de l'opération de charge de ladite batterie.

2. Méthode selon la revendication 1, caractérisée en ce que la mesure de ladite capacité à pleine charge de ladite batterie est effectuée après qu'une période de temps prédéterminée s'est écoulée (S10-S12, fig. 8) depuis la fin de l'opération de charge de ladite batterie.

3. Méthode selon la revendication 1 ou 2, caractérisée en ce que ladite capacité à pleine charge de ladite batterie est mesurée en détectant la tension de ladite batterie, et après que ladite capacité à pleine charge de ladite batterie a été mesurée, une compensation basée sur la température de ladite batterie est effectuée afin de calculer une capacité de charge réelle (S9, S13, S13-S18).

4. Méthode selon la revendication 1, 2 ou 3, caractérisée en ce que la mesure de ladite capacité à pleine charge de ladite batterie est effectuée en comparant une tension de décharge de ladite batterie pendant une période de temps prédéterminée avec une caractéristique de décharge de référence obtenue à l'avance (S15, S16, fig. 9).
